# EUROPEAN PATENT APPLICATION

(11) **EP 2 660 888 A1**
(43) Date of publication of application: **06.11.2013**
(21) Application number: 11854081.4
(22) Date of filing: 27.12.2011
(51) Int. Cl.: H01L 35/32, H02N 11/00

(54) **THERMOELECTRIC CONVERSION MEMBER**

(30) Priority: 28.12.2010 JP 2010292375
(71) Applicant: Kyocera Corporation, Kyoto-shi Kyoto 612-8501 (JP)
(72) Inventor: YUGUCHI, Akio, Kyoto-shi Kyoto 612-8501 (JP)
(74) Representative: HOFFMANN EITLE
(86) International application number: PCT/JP2011/080289
(87) International publication number: WO 2012/091048

(57) **Abstract**

[Object] To maintain a relatively good temperature difference between the two ends of a thermoelectric conversion element.

[Solution] To provide a thermoelectric conversion member which includes a first substrate 11 having an insulating property, a plurality of first electrodes 31 arranged in a row in one direction on one principal surface 11A of the first substrate 11, a second substrate 12 having an insulating property and having a principal surface 12A facing the one principal surface 11A, a plurality of second electrodes 32 arranged in a row on the facing principal surface 12A of the second substrate 12 so as to be opposed to corresponding first electrodes 31, a plurality of thermoelectric conversion elements 2 which are composed of an n-type semiconductor, disposed in a space between the first substrate 11 and the second substrate 12, and joined to corresponding first electrodes 31 and corresponding second electrodes 32, and a conductive part 33, being connected to the first electrode 31 joined to one thermoelectric conversion element 2 and being connected to the second electrode 32 joined to another thermoelectric conversion element 2 placed adjacent in the one direction to the one thermoelectric conversion element 2, the conductive part 33 electrically connecting in series the adjacent thermoelectric conversion elements 2. The conductive part 33 lies only outside the gap region between the one thermoelectric conversion element 2 joined to the first electrode 31 to which it is connected and the other thermoelectric conversion element 2 joined to the second electrode 32 to which it is connected.

## Description

### Technical Field

The present invention relates to a thermoelectric conversion member.

### Background Art

Thermoelectric conversion members for converting heat energy into electrical energy or converting electrical energy into heat energy have been proposed in the related art. By using thermoelectric conversion elements, for example, heat energy exhausted from internal combustion engines of automobiles, boats, and the like can be converted into electrical energy. A thermoelectric conversion member includes a thermoelectric conversion element in which, when a temperature difference is provided between the two ends thereof, electric power can be obtained. In the case where a thermoelectric conversion member is used in a power generation application, in order to maintain stable power generation efficiency, it is necessary to keep a certain temperature difference or more between the two ends of a thermoelectric conversion element.

For example, Patent Literature 1 (Japanese Unexamined Patent Application Publication No. 2010-205883) discloses a thermoelectric conversion member which includes a pair of substrates, a plurality of electrodes on each of the surfaces of the substrates facing each other, and a plurality of n-type thermoelectric conversion elements, one end of each of the thermoelectric conversion elements being electrically connected to the electrode on one of the substrates, the other end of each of the thermoelectric conversion elements being electrically connected to the electrode on the other one of the substrates. In the thermoelectric conversion member disclosed in Patent Literature 1, conductive parts for electrically connecting in series the plurality of n-type thermoelectric conversion elements are arranged in the gaps between the plurality of n-type thermoelectric conversion elements.

### Summary of Invention

In a known thermoelectric conversion member, such as the one disclosed in Patent Literature 1, conductive parts composed of a metal are arranged in the gaps between thermoelectric conversion elements, and a large amount of radiant heat from the substrate on which the thermoelectric conversion elements and electrodes are disposed reaches the conductive parts. Consequently, the conductive parts are heated, and a large amount of heat flows, through the conductive parts, into the low-temperature side electrode, resulting in a decrease in the temperature difference in the thermoelectric conversion elements, which is a problem. Such a problem that the conductive parts are heated becomes more noticeable as the overall size of the thermoelectric conversion member decreases and the gaps between the thermoelectric conversion elements decrease, which limits size reduction of the thermoelectric conversion member. Furthermore, in the thermoelectric conversion member disclosed in Patent Literature 1, it requires a lot of time and effort to arrange conductive parts for connecting in series the n-type thermoelectric conversion elements in the gaps between the thermoelectric conversion elements, and it is not possible to manufacture the thermoelectric conversion member at a relatively low cost. The present invention has been achieved in order to solve such problems.

The present invention provides a thermoelectric conversion member which includes a first substrate having an insulating property, a plurality of first electrodes arranged in a row in one direction on one principal surface of the first substrate, a second substrate having an insulating property and having a principal surface facing the one principal surface, a plurality of second electrodes arranged in a row on the facing principal surface of the second substrate so as to be opposed to corresponding first electrodes, a plurality of thermoelectric conversion elements which are composed of an n-type semiconductor, disposed in a space between the first substrate and the second substrate, and joined to corresponding first electrodes and corresponding second electrodes, and a conductive part, being connected to the first electrode joined to one thermoelectric conversion element and being connected to the second electrode joined to another thermoelectric conversion element placed adjacent in the one direction to the one thermoelectric conversion element, the conductive part electrically connecting in series the adjacent thermoelectric conversion elements. The conductive part lies only outside the gap region between the one thermoelectric conversion element joined to the first electrode to which it is connected and the other thermoelectric conversion element joined to the second electrode to which it is connected.

According to the present invention, even in the case where thermoelectric conversion elements are arranged, at a high density, with a relatively small gap therebetween, it is possible to maintain a relatively good temperature difference between the two ends of each of the thermoelectric conversion elements.

### Brief Description of Drawings

[Fig. 1] Fig. 1 includes views explaining a thermoelectric conversion member according to a first embodiment of the present invention: Fig. 1(a) is a perspective view of a thermoelectric conversion member 1, Fig. 1(b) is a front view, Fig. 1(c) is a side view, and Fig. 1(d) is a cross-sectional view taken along the line A-A' of Fig. 1(c).
[Fig. 2] Fig. 2 includes views explaining a thermoelectric conversion member according to a second embodiment of the present invention: Fig. 2(a) is a schematic perspective view of the thermoelectric conversion member, Fig. 2(b) is a front view, Fig. 2(c) is a side view, and Fig. 2(d) is a cross-sectional view taken along the line A-A' of Fig. 2(c).
[Fig. 3] Fig. 3(a) is a side view of a thermoelectric conversion member according to a third embodiment of the present invention, and Fig. 3(b) is a front view of a thermoelectric conversion member according to a fourth embodiment of the present invention.
[Fig. 4] Fig. 4 includes side views explaining an example of a method of manufacturing the thermoelectric conversion member shown in Fig. 1.
[Fig. 5] Fig. 5 includes top views explaining an example of a method of manufacturing the thermoelectric conversion member shown in Fig. 1.

### Description of Embodiments

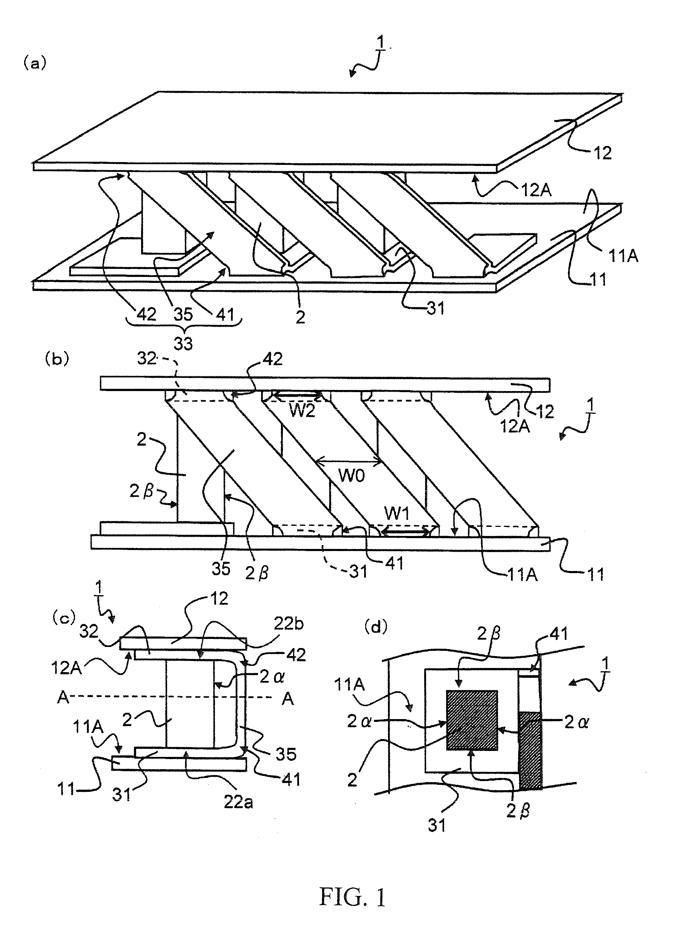

A thermoelectric conversion member according to a first embodiment of the present invention will be described with reference to Fig. 1. Fig. 1(a) is a perspective view of the thermoelectric conversion member according to the first embodiment of the present invention, Fig. 1(b) is a front view, Fig. 1(c) is a side view, and Fig. 1(d) is a cross-sectional view taken along the line A-A' of Fig. 1(c). A thermoelectric conversion member 1 includes a first substrate 11 having an insulating property, first electrodes 31 arranged in a row in one direction on one principal surface 11A of the first substrate 11, a second substrate 12 having an insulating property and having a principal surface 12A facing the one principal surface 11A, a plurality of second electrodes 32 arranged at positions facing corresponding first electrodes 31 on the principal surface 12A, a plurality of thermoelectric conversion elements 2 which are composed of an n-type semiconductor, disposed in a space between the first substrate 11 and the second substrate 12, and joined to corresponding first electrodes 31 and corresponding second electrodes 32, and conductive parts 33, each being connected to the first electrode 31 joined to one thermoelectric conversion element 2 and being connected to the second electrode 32 joined to another thermoelectric conversion element 2 placed adjacent in the one direction to the one thermoelectric conversion element 2, the conductive parts 33 electrically connecting in series the adjacent thermoelectric conversion elements 2 (hereinafter, the one direction is referred to as the "element arranging direction"). In the thermoelectric conversion member 1, each of the conductive parts 33 is disposed only outside the gap region between the one thermoelectric conversion element 2 joined to the first electrode 31 to which it is connected and the other thermoelectric conversion element 2 joined to the second electrode 32 to which it is connected.

The substrate 11 is a ceramic substrate containing, as a main component, alumina (Al₂O₃). The first electrodes 31, the second electrodes 32, and the conductive parts 33 are composed of copper (Cu). The first electrodes 31, The second electrodes 32, and The conductive parts 33 are formed by bending a copper plate. Alumina (Al₂O₃) is suitable from the viewpoint of inexpensiveness and a good insulating property, and copper (Cu) is suitable from the viewpoint of inexpensiveness and low electrical resistance. In the thermoelectric conversion member, the materials for the insulating substrates, the electrodes, and the conductive parts are not particularly limited.

The thermoelectric conversion element 2 according to this embodiment is an n-type thermoelectric conversion element containing, as a main component, Mg₂Si. In the related art, BiTe, PbTe, and CoSb have been used as materials for thermoelectric conversion elements. However, thermoelectric conversion elements composed of these materials are relatively expensive. In contract, Mg₂Si is relatively inexpensive and has a low impact on the environment. Furthermore, since Mg₂Si has a relatively small specific gravity, by using a thermoelectric conversion element 2 containing, as a main component, Mg₂Si, it is possible to produce a thermoelectric conversion member 1 having a relatively small weight. In these respects, the thermoelectric conversion element preferably contains, as a main component, Mg₂Si.

One end 22a of a thermoelectric conversion element 2 is joined to a first electrode 31, and another end 22b of the thermoelectric conversion element 2 is joined to a second electrode 32. As the joining method, soldering, brazing, or bonding using a conductive adhesive, such as silver paste, can be used. The joining method may be appropriately selected depending on the application of the thermoelectric conversion member or the like. In the case where joining is performed by brazing, a brazing alloy, in the form of paste, may be applied in advance to the two ends of the thermoelectric conversion element 2. The thermoelectric conversion element 2 has fine irregularities on its surfaces. By covering irregularities of the surfaces with a brazing alloy, silver paste, or the like, smooth surfaces can be obtained. Thereby, the joining state between the thermoelectric conversion element 2 and each of the first electrode 31 and the second electrode 32 improves and good conductivity can be secured.

When the second substrate 12 of the thermoelectric conversion member 1 is attached to a heat source and the substrate 11 is kept at a lower temperature than the heat source, a temperature difference is produced between the two ends of each of a plurality of thermoelectric conversion elements 2, and the Seebeck effect causes an electric current to flow. The thermoelectric conversion elements 2 are electrically connected in series by a plurality of first electrodes 31, second electrodes 32, and conductive parts 33, and the electric current can be extracted to the outside through the first electrodes 31 or second electrodes 32. In such a manner, the thermoelectric conversion member 1 serves as a power generator which outputs an electric current to an external circuit. For example, by bringing the second substrate 12 into contact with a heat-dissipating portion of a device from which excess heat energy is discharged, such as a back side of a highly integrated circuit board or a surface of a casing of an internal combustion engine, e.g. an engine of an automobile or boat, and by placing the first substrate 11 at a position having a lower temperature than that of the second substrate 12, the thermoelectric conversion member 1 can be made to operate as a power generator.

In order to continue power generation efficiently using such a thermoelectric conversion member, it is necessary to maintain a certain magnitude of temperature difference between the two ends of the thermoelectric conversion element 2. In this embodiment, Mg₂Si having low thermal conductivity is used as the material for the thermoelectric conversion element 2, and the temperature difference can be maintained relatively satisfactorily.

In this embodiment, the conductive parts 33 are disposed only outside the gaps between a plurality of thermoelectric conversion elements 2. Thus, radiant heat from the thermoelectric conversion elements 2 is relatively unlikely to reach the conductive parts 33, and the conductive parts 33 are suppressed from being heated. Consequently, it is possible to maintain a predetermined temperature difference between the two ends of each of the thermoelectric conversion elements 2.

In the thermoelectric conversion member 1, the one principal surface 11A of the first substrate 11 faces, in parallel, the principal surface 12A of the second substrate 12. Furthermore, the thermoelectric conversion elements 2 have a rectangular parallelepiped shape including a pair of first side surfaces 2α which are perpendicular to the one principal surface 11A of the first substrate 11 and parallel to the element arranging direction and a pair of second side surfaces 2β which are perpendicular to the one principal surface 11A of the first substrate 11 and perpendicular to the element arranging direction. The thermoelectric conversion elements 2 having such a rectangular parallelepiped shape can be arranged, at a high density, along the arranging direction.

Each of the conductive parts 33 includes a plate-like portion 35 having a principal surface 33α which faces, in parallel, a part of the first side surface 2α of the thermoelectric conversion element 2. The plate-like portion 35 also serves as a supporting member which keeps a predetermined distance between the first substrate 11 and the second substrate 12, and prevents excess stress from being transmitted from the first substrate 11 or the second substrate 12 to the thermoelectric conversion element 2.

Furthermore, in the thermoelectric conversion member 1, the width W0 in the element arranging direction of the plate-like portion 35 is the same from the first substrate 11 side end to the second substrate 12 side end. The plate-like portion 35 has a parallelogram shape in side view in Fig. 1(b). The plate-like portion 35 has a relatively large surface area. The heat transmitted from the high-temperature side is efficiently dissipated from the surface of the plate-like portion 35, and in the thermoelectric conversion element 2, the difference in temperature between the first substrate 11 side end and the second substrate 12 side end is kept relatively large.

Each of the the conductive parts 33 includes a first bent portion 41 which extends from the first substrate 11 side end of the plate-like portion 35 to the first electrode 31 and bends from the plate-like portion 35 toward the first electrode 31, and a second bent portion 42 which extends from the second substrate 12 side end of the plate-like portion 35 to the second electrode 32 and bends from the plate-like portion 35 toward the second electrode 32. The width W1 in the element arranging direction of the first bent portion 41 is smaller than each of the width of the first electrode 31 and the width of the first substrate 11 side end of the plate-like portion 35, and the width W2 in the element arranging direction of the second bent portion 42 is smaller than each of the width of the second electrode 32 and the width of the second substrate 12 side end of the plate-like portion 35. Since the width W1 in the element arranging direction of the bent portion 41 and the width W2 in the element arranging direction of the bent portion 42 are small, heat conduction between the first electrode 31 and the plate-like portion 35 and heat conduction between the second electrode 32 and the plate-like portion 35 are suppressed, and along with efficient heat dissipation from the plate-like portion 35, the temperature difference between the first electrode 35 and the second electrode 32 is kept relatively large.

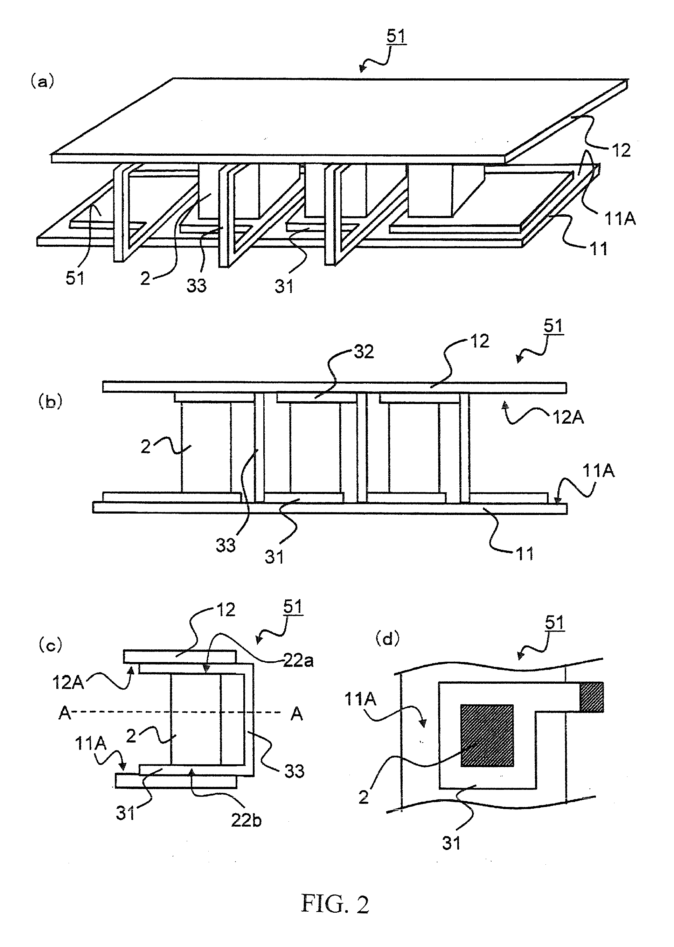

Fig. 2 includes views explaining a thermoelectric conversion member 51 according to a second embodiment of the present invention. Fig. 2(a) is a schematic perspective view of the thermoelectric conversion member 51, Fig. 2(b) is a front view, Fig. 2(c) is a side view, and Fig. 2(d) is a cross-sectional view taken along the line A-A of Fig. 2(c). In Fig. 2, the same reference numerals are used for the same components as those of the first embodiment shown in Fig. 1.

In the second embodiment shown in Fig. 2, each of conductive parts 33 is disposed only outside the space between a first substrate 11 and a second substrate 12. Consequently, in particular, radiant heat from the second substrate 12 on the high-temperature side is relatively unlikely to reach the conductive parts 33, and it is possible to suppress an increase in the resistance value of the conductive part 33 due to an increase in the temperature of the conductive part 33. Furthermore, in this embodiment, the width in the element arranging direction of the conductive part 33 is set to be smaller than each of the length in the element arranging direction of the first electrode 31 and the length in the element arranging direction of the second electrode 32. Consequently, heat from the second electrode 32 on the high-temperature side is suppressed from reaching, through the conductive part 33, the first electrode 31 on the low-temperature side, and a predetermined temperature difference between the two ends of the thermoelectric conversion element 2 is satisfactorily maintained. The second embodiment can be suitably used, for example, in the case where the temperature of the high-temperature side is significantly high, and suppression of heat conduction to the low-temperature side is desired.

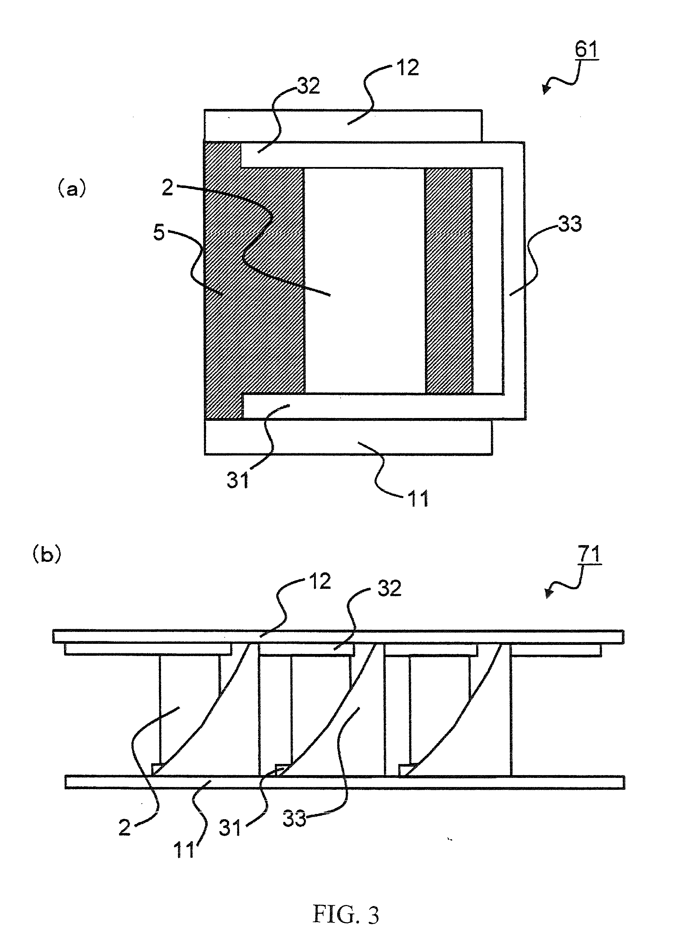

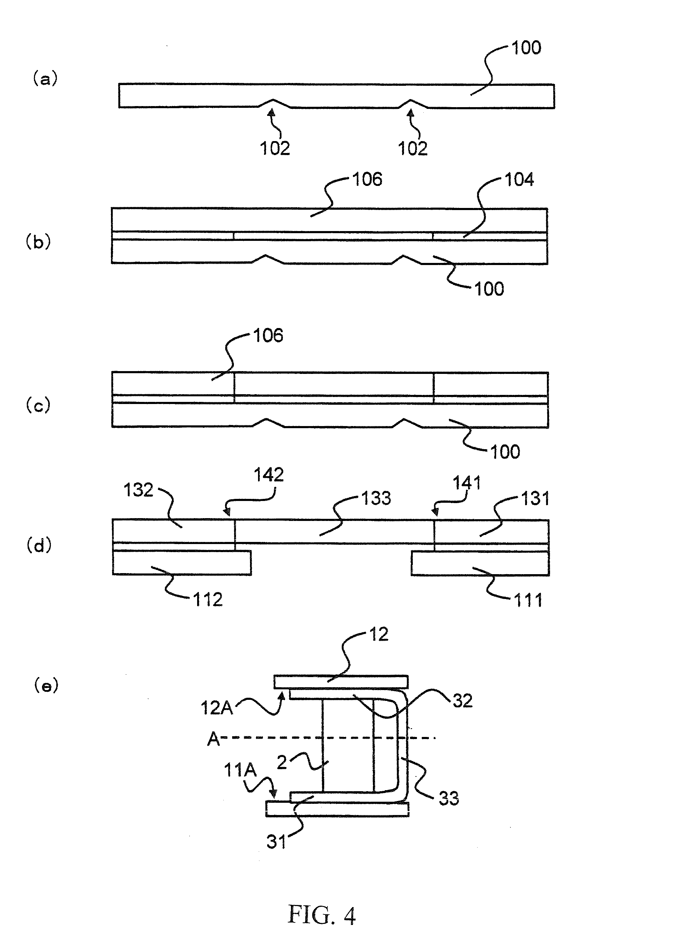

Fig. 3(a) is a side view of a thermoelectric conversion member according to a third embodiment of the present invention, and Fig. 3(b) is a front view of a thermoelectric conversion member according to a fourth embodiment of the present invention. In Figs. 3 and 4, the same reference numerals are used for the same components as those of the first embodiment shown in Fig. 1.

A thermoelectric conversion member 61 shown in Fig. 3(a) differs from the first embodiment and the second embodiment in that a heat insulating member 5 is disposed in the space between the first substrate 11 and the second substrate 12. In the third embodiment, the heat insulating member 5 inhibits heat on the high-temperature side from dispersing into the air. In the third embodiment, in the case where the temperature on the high-temperature side is not so high compared with the ambient atmosphere, a decrease in temperature of the second substrate 12 can be suppressed, and a temperature difference between the first substrate 11 and the second substrate 12 can be secured more appropriately. As the heat insulating member 5, a porous body of silicon oxide or alumina is preferably used. However, another material may be used. Furthermore, since conductive parts 33 are disposed outside the gaps between thermoelectric conversion elements 2, it is possible to dispose the heat insulating member 5 in the whole space between the first substrate 11 and the second substrate 12 and in the whole gaps between the thermoelectric conversion elements. Thus, dispersion of heat can be effectively inhibited by the heat insulating member 5.

A thermoelectric conversion member 71 according to the fourth embodiment shown in Fig. 3(b) differs from the first embodiment in that the width in the thermoelectric conversion element 2 arranging direction of the conductive part 33 decreases with distance from the first electrode 31 to the second electrode 32. The conductive part 33 is a path through which heat from the second substrate 12 on the high-temperature side is transmitted, and also is a region from which the heat is dissipated. In the fourth embodiment, the cross-sectional area on the second substrate 12 side which is the high-temperature side is small, thus suppressing transmission of heat from the second substrate 12 to the first substrate 11, and the surface area of the first substrate 11 side is large, thus relatively satisfactorily dissipating excess heat. In the third embodiment, for example, in the case where the temperature on the high-temperature side is significantly high compared with the ambient temperature, by suppressing the amount of heat flowing into the conductive parts 33, the temperature difference between the first substrate 11 and the second substrate 12 can be more appropriately secured.

In the thermoelectric conversion member of the present invention, the conductive parts 33 are disposed outside the gaps between the thermoelectric conversion elements 2, degree of freedom in design of the shape of the conductive parts33 is high, and each of the structures of the first to fourth embodiments can be easily achieved. Although not shown in the drawing, a radiating fin may be provided on the surface of the conductive parts 33 so that heat dissipation from the conductive parts 33 can be improved. The size and shape of the conductive parts 33 influence the electrical resistance of the conductive parts 33 and the heat conduction of the conductive parts 33. The shape and size of the conductive parts 33 may be selected depending on the environment in which the thermoelectric conversion member 1 is placed, conditions of use of the thermoelectric conversion member 1, the shape and size of the thermoelectric conversion elements 2, and the like so that desired characteristics can be obtained. The shape and size of the conductive parts 33 are not particularly limited.

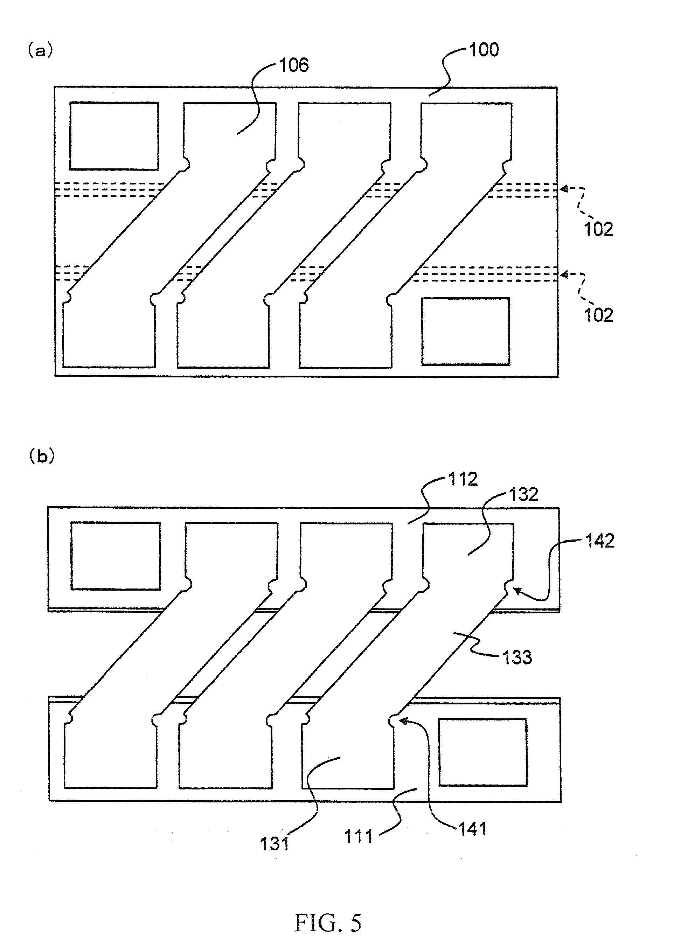

An example of a method of manufacturing a thermoelectric conversion member 1 will now be described with reference to Figs. 4 and 5. Fig. 4 includes side views, and Fig. 5 includes top views.

First, as shown in Fig. 4(a), an insulating substrate 100 containing, as a main component, alumina (Al₂O₃) is prepared. Cut portions 102 having a triangular cross section are provided on a lower principal surface of the insulating substrate 100 shown in Fig. 4.

Next, as shown in Fig. 4(b), a copper plate 106 is joined to the substrate 100 through a joining layer 104.
The joining layer 104 may be composed of a known brazing alloy. In the state shown in Fig. 4(b), using a known photolithographic technique, the copper plate 106 is patterned into a predetermined shape as shown in Fig. 4(c). Fig. 5(a) is a top view which corresponds to the shape after etching in Fig. 4(c).

In this etching step, for example, an etching mask composed of a resist or the like is selectively applied to the copper plate, and then the entire workpiece is immersed in a ferric chloride solution which is an etchant. In this etching, the copper plate is selectively etched.

After the etching, as shown in Fig. 4(d), a part of the substrate 100 is removed. As described above, the cut portions 102 are provided in advance on the substrate 100, and by applying mechanical pressure, a region sandwiched between the cut portions 102 can be removed. Note that, without providing the cut portions 102, a part of the substrate 100 may be removed by cutting using a dicing device or the like. As shown in Figs. 4(d) and 5(b), the shape after the removal has a structure in which a plurality of portions 131 corresponding to first electrodes and a plurality of portions 132 corresponding to second electrodes are joined to the surfaces of remaining portions 111 and 112 of the substrate 100, respectively, and the portions 131 corresponding to first electrodes and the portions 132 corresponding to second electrodes are joined to each other through portions 133 corresponding to conductive parts. A portion 141 corresponding to a first bent portion is disposed between each of the portions 133 corresponding to conductive parts and each of the portions 131 corresponding to first electrodes, and a portion 142 corresponding to a second bent portion is disposed between each of the portions 133 corresponding to conductive parts and each of the portions 131 corresponding to second electrodes.

Next, the portions 141 corresponding to first bent portions and the portions 142 corresponding to second bent portions are bent such that the upper principal surface of the remaining portion 111 of the substrate 100 shown in Fig. 4 and the upper principal surface of the remaining portion 112 shown in Fig. 4 are opposed to each other. Thermoelectric conversion elements 2 are disposed in a space between the portions 131 corresponding to first electrodes and the portions 132 corresponding to second electrodes, and, for example, using a conductive adhesive, such as silver paste, ends of each of the thermoelectric conversion elements 2 are bonded to each of the portions 131 corresponding to first electrodes and each of the portions 132 corresponding to second electrodes. In such a manner, a thermoelectric conversion member 1 according to the first embodiment as shown in Fig. 4(e) can be fabricated. In the manufacturing method of this embodiment, a thermoelectric conversion member can be manufactured relatively easily at a low cost.

In each of the embodiments described above, the thermoelectric conversion elements 2 having a rectangular parallelepiped shape are shown. However, the shape of the thermoelectric conversion elements is not limited to such a rectangular parallelepiped shape, but may be another shape, such as a cylindrical shape. The shape, number, and height of the thermoelectric conversion elements and the size and thickness of the conductive parts 33 may be appropriately selected in consideration of securement of a temperature difference in the thermoelectric conversion elements 2, radiant heat from the high-temperature side, heat conduction, mechanical strength of the thermoelectric conversion elements 2, and the like.

Furthermore, in this embodiment, the thermoelectric conversion elements 2 are formed of Mg₂Si. However, the material for the thermoelectric conversion elements 2 is not limited thereto, but any thermoelectric conversion material may be used. Examples thereof include Bi-Te-based materials including Sb-Te-based materials and Bi-Se-based materials, Pb-Te-based materials including Sn-Te-based and Ge-Te-based materials, Ag-Sb-Te-based materials, Ag-Sb-Ge-Te-based materials, Si-Ge-based materials, Fe-Si-based materials, Mn-Si-based materials, Zn-Sb-based materials, chalcogenides, skutterudites, filled skutterudites, boron carbide, and layered cobalt oxides. Furthermore, the thermoelectric conversion elements 2 are not limited to n-type, but p-type elements may be used. Furthermore, Mg₂Si is not necessarily of high purity. For example, Mg₂Si obtained by using silicon waste sludge discharged during the grinding/polishing process may be used.

Furthermore, the electrodes are not limited to Cu. Any electrode material, such as Ni, Al, Cu, W, Au, Ag, Co, Mo, Cr, Ti, Pd, or an alloy of these metals, a transition metal silicide, TiN, or AiTiN, may be used.

In each of the embodiments described above, the thermoelectric conversion elements 2 in the thermoelectric conversion member 1 used for power generation using the Seebeck effect have been described. However, thermoelectric conversion elements of the present invention can also be used in a thermoelectric conversion member which performs cooling or heating using the Peltier effect.

### Reference Signs List

- 1: thermoelectric conversion member
- 2: thermoelectric conversion element
- 2α: first side surface
- 2β: second side surface
- 11: first substrate
- 11A: one principal surface
- 12: second substrate
- 12A: principal surface
- 22a: one end
- 22b: another end
- 31: first electrode
- 32: second electrode
- 33: conductive part
- 35: plate-like portion
- 100: substrate
- 102: cut portion
- 104: joining layer
- 106: copper plate
- 111, 112: remaining portion
- 131: portion corresponding to first electrode
- 132: portion corresponding to second electrode 132

## Claims

1. A thermoelectric conversion member comprising:
a first substrate having an insulating property;
a plurality of first electrodes arranged in a row in one direction on one principal surface of the first substrate;
a second substrate having an insulating property and having a principal surface facing the one principal surface;
a plurality of second electrodes arranged in a row on the facing principal surface of the second substrate so as to be opposed to corresponding first electrodes;
a plurality of thermoelectric conversion elements which are composed of an n-type semiconductor, disposed in a space between the first substrate and the second substrate, and joined to corresponding first electrodes and corresponding second electrodes; and
a conductive part, being connected to the first electrode joined to one thermoelectric conversion element and being connected to the second electrode joined to another thermoelectric conversion element placed adjacent in the one direction to the one thermoelectric conversion element, the conductive part electrically connecting in series the adjacent thermoelectric conversion elements,
wherein the conductive part lies only outside the gap region between the one thermoelectric conversion element joined to the first electrode to which it is connected and the other thermoelectric conversion element joined to the second electrode to which it is connected.

2. The thermoelectric conversion member according to Claim 1, wherein the one principal surface of the first substrate faces, in parallel, the facing principal surface of the second substrate, and the thermoelectric conversion elements have a rectangular parallelepiped shape including a pair of first side surfaces which are perpendicular to the one principal surface of the first substrate and parallel to the one direction and a pair of second side surfaces which are perpendicular to the one principal surface of the first substrate and perpendicular to the one direction.

3. The thermoelectric conversion member according to Claim 2, wherein the conductive part includes a plate-like portion having a principal surface which faces, in parallel, a part of one of the two first side surfaces of the thermoelectric conversion element.

4. The thermoelectric conversion member according to Claim 3, wherein the conductive part includes a first bent portion which extends from the first substrate side end of the plate-like portion to the first electrode and bends from the plate-like portion toward the first electrode, and a second bent portion which extends from the second substrate side end of the plate-like portion to the second electrode and bends from the plate-like portion toward the second electrode, and
wherein the width in the one direction of the first bent portion is smaller than each of the width of the first electrode and the width of the first substrate side end of the plate-like portion, and the width in the one direction of the second bent portion is smaller than each of the width of the second electrode and the width of the second substrate side end of the plate-like portion.

5. The thermoelectric conversion member according to Claim 3, wherein the width in the one direction of the plate-like portion is the same from the first substrate side end to the second substrate side end.

6. The thermoelectric conversion member according to Claim 1, wherein the width in the one direction of the conductive part is smaller than each of the length in the one direction of the first electrode and the length in the one direction of the second electrode.

7. The thermoelectric conversion member according to Claim 1, wherein the width in the one direction of the conductive part decreases with distance from the first electrode to the second electrode.

8. The thermoelectric conversion member according to Claim 1, wherein the conductive part lies outside the space between the first substrate and the second substrate.
